Europäisches Patentamt

European Patent Office

Office européen des brevets

(19)

(11) Veröffentlichungsnummer: **0 261 526 B1**

(12) # EUROPÄISCHE PATENTSCHRIFT

(45) Veröffentlichungstag der Patentschrift: **28.08.91**

(51) Int. Cl.5: **G01R 21/127**, G01R 17/06

(21) Anmeldenummer: **87113337.7**

(22) Anmeldetag: **11.09.87**

(54) **Elektronischer Elektrizitätszähler.**

(30) Priorität: **19.09.86 DE 3631961**

(43) Veröffentlichungstag der Anmeldung:
**30.03.88 Patentblatt 88/13**

(45) Bekanntmachung des Hinweises auf die
Patenterteilung:
**28.08.91 Patentblatt 91/35**

(84) Benannte Vertragsstaaten:
**AT BE CH DE FR GB IT LI NL SE**

(56) Entgegenhaltungen:
**EP-A- 0 100 102**
**EP-A- 0 134 001**
**WO-A-85/00894**
**DE-T- 3 490 349**

**TECHNISCHES MESSEN ATM, Band 45, Nr. 11, 1978, Seiten 407-411; G. STEINMÜLLER: "Ein genauer elektronischer Elektrizitätszähler"**

(73) Patentinhaber: **Siemens Aktiengesellschaft**
**Wittelsbacherplatz 2**
**W-8000 München 2(DE)**

(72) Erfinder: **Steinmüller, Günter, Dipl.-Ing.**
**Laufamholzstrasse 65**
**W-8500 Nürnberg(DE)**

## Beschreibung

Die Erfindung betrifft einen elektronischen Elektrizitätszähler nach dem Oberbegriff des Patentanspruches 1.

Aus der DE-T-34 90 349 ist es bekannt, in Zusammenhang mit elektronischen Elektrizitätszählern eine Offsetspannungs-Kompensationsvorrichtungder eingangs genannten Art vorzusehen. Dabei wird zur Offsetspannungs-Kompensation zusätzlich der Ausgang des Operationsverstärkers über einen Schalter auf dessen invertierenden Eingang zurückgekoppelt. Diese Offsetspannungs-Kompensationsvorrichtung bedingt regelmäßige, wenn auch nur kurze Unterbrechungen im Signalweg. Zur Abhilfe werden daher in der genannten Venöffentlichung zwei weitere Möglichkeiten der Offsetspannungs-Kompensation vorgeschlagen, die ohne Unterbrechung des Signalwegs auskommen. Bei einer ersten Version wird die Offsetspannung mit einem Ladeverstärker abgetastet und in Abhängigkeit von der verbleibenden Offsetspannung ein Kompensationskondensator aufgeladen. In einer zweiten Version sind zwei Signalwege vorhanden, bei denen abwechselnd in einem Signalweg ein Kondensator auf die Offsetspannung aufgeladen wird und ein zweiter Signalweg die Signalverarbeitung übernimmt. Diese beiden Versionen kommen zwar ohne Signalunterbrechung aus, dafür ist jedoch für die Offsetspannungs-Kompensation ein zusätzlicher Verstärker erforderlich.

Aufgabe der Erfindung ist es daher, bei einem elektronischen Elektrizitätszähler eine Offsetspannungs-Kompensation mit geringerem Aufwand durchzuführen.

Diese Aufgabe wird durch die in Patentanspruch 1 beschriebene Erfindung gelöst.

Auch bei dieser Art der Offsetspannungs-Kompensation tritt zwar eine Unterbrechung des Signalweges auf. Dies wirkt sich jedoch nicht störend aus, da die Anordnung mit den übrigen Funktionselementen des Elektrizitätszählers so zusammenwirkt, daß während der Zeitspannen $\Delta$ t aufgrund der geöffneten Eingangsschalter ohnehin kein Signal auftritt, d.h. der Integrator auf seinem abgespeicherten Stand stehen bleibt.

Vorteilhafte Ausführungsformen der Erfindung sind in den Unteransprüchen beschrieben.

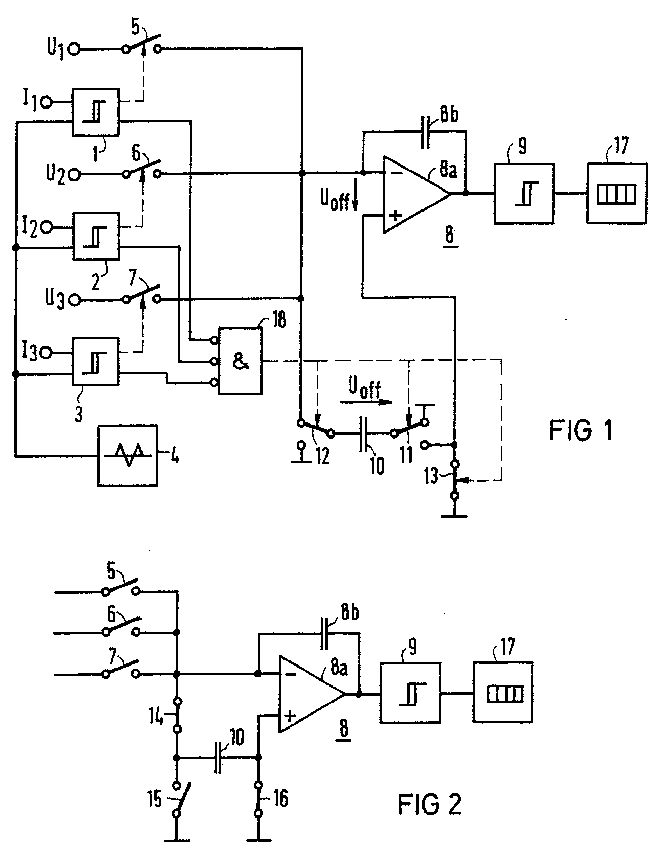

Ausführungsbeispiele der Erfindung werden nachfolgend anhand der Fig. 1 und 2 näher erläutert.

Fig. 1 zeigt einen elektronischen Elektrizitätszähler, der nach dem beispielsweise aus der Literaturstelle "Technisches Messen ATM" 1978, Heft 11, Seiten 407-411 bekannten Time Division-Multiplikationsverfahren arbeitet. Im einem Drehstromsystem werden die drei Phasenspannungen $U_1$ - $U_3$ über je einen Eingangsschalter 5-7 einem Integrator 8 zugeführt. Jeder Eingangsschalter 5-7 wird von dem der jeweiligen Phase zugeordneten Strom $I_1$ -$I_3$ über einen Modulator 1-3 angesteuert. Jeder Modulator 1-3 steuert den zugeordneten Schalter 5-7 mit einem Ein-/Ausschaltverhältnis, das dem jeweiligen Strom $I_1$ - $I_3$ proportional ist. Damit entsteht für jede Phase eine Spannung, die dem Produkt aus Spannung $U_1$-$U_3$ und Strom $I_1$-$I_3$ proportional ist. Diese Spannungen werden für alle drei Phasen mit dem Integrator 8 aufsummiert.

Das dem jeweiligen Strom $I_1$-$I_3$ proportionale Ein-Ausschaltverhältnis erhält man, indem jeder Modulator 1 bis 3 aus einem Komparator besteht, von dem jeweils ein erster Eingang mit einem gemeinsamen Dreieckgenerator 4 verbunden ist und dem zweiten Eingang der jeweilige Strom-Meßwert $I_1$-$I_3$ zugeführt wird. Dabei ist die Amplitude der Dreieckspannung so gewählt, daß sie in jedem Fall größer ist als die größte Stromamplitude, für die der Zähler zugelassen ist. In der Nähe der Amplitude, d.h. der Spitze der Dreieckspannung, gibt es daher stets eine Zeitspanne $\Delta$ t, in der keiner der Schalter 5 bis 7 geschlossen ist, so daß während dieser Zeitspanne $\Delta$ t dem Integrator 8 kein Signal zugeführt wird. Der Integrator 8 besteht in bekannter Weise aus einem Operationsverstärker 8a, der zwischen Ausgang und invertierendem Eingang mit einem Integrationskondensator 8b beschaltet ist. An den invertierenden Eingang sind ferner die Schalter 5-7 angeschlossen.

Am Ausgang des Integrators 8 steht damit die aufintegrierte Eingangsspannung zur Verfügung, die mit dem Komparator 9 in eine Impulsfolge umgesetzt wird, deren Frequenz der gemessenen Leistung proportional ist. Die Ausgangsimpulse werden wiederum einer Anzeigevorrichtung 17 mit einer Summiereinrichtung zugeführt, so daß schließlich die elektrische Arbeit angezeigt wird.

Ohne Offsetspannungs-Kompensation würde der Integrator 8 auch die an seinem Eingang anstehende Offsetspannung $U_{off}$ mit integrieren, was somit das Meßergebnis verfälschen würde.

Zur Abhilfe ist ein Kompensationskondensator 10 vorgesehen, der beidseitig an Umschalter 11 bzw. 12 angeschlossen ist. Mit dem Umschalter 12 ist ein Anschluß des Kompensationskondensators 10 wahlweise mit Bezugspotential oder mit dem invertierenden Eingang des Operationsverstärkers 8a verbindbar. Mit dem Umschalter 11 ist der zweite Anschluß des Kompensationskondesators 10 wahlweise mit Bezugspotential oder mit dem nichtinvertierenden Eingang des Operationsverstärkers 8 verbindbar. Ferner ist der nichtinvertierende Eingang des Operationsverstärkers 8 über einen Schalter 13 mit Bezugspotential verbindbar.

Alle Schalter sind in der Stellung während der Zeitspanne $\Delta$ t gezeichnet, während also alle Eingangsschalter 5-7 geöffnet sind. Die Schalter 11-13 werden dazu von einem UND-Gatter 18 angesteuert, an dessen drei invertierenden Eingängen die Ausgangssignale der Modulatoren 1 bis 3 anstehen. Das UND-Gatter 18 liefert ausgangsseitig nur dann ein "1"-Signal, wenn alle Schalter 5-7 geöffnet sind. In dieser Zeitspanne Δ t ist also der nichtinvertierende Eingang des Operationsverstärkers 8 über den Schalter 13 mit Bezugspotential und der invertierende Eingang des Operationsverstärkers 8 über den Umschalter 12, den Kompensationskondensator 10 und den Umschalter 11 ebenfalls mit Bezugspotential verbunden. Damit wird der Kompensationskondensator 10 auf die am Eingang des Operationsverstärkers 8 anstehende Offsetspannung $U_{off}$ aufgeladen.

Nach Beendigung der Zeitspanne Δ t wechseln die Umschalter 11 und 12 und der Schalter 13 ihre Stellungen, so daß nunmehr der invertierende Eingang des Operationsverstärkers 8a nicht mehr mit der Offsetspannungs-Kompensationsvorrichtung verbunden ist und der nichtinvertierende Eingang des Operationsverstärkers 8 über den Umschalter 11, den Kompensationskondensator 10 und den Umschalter 12 mit Bezugspotential verbunden ist.

Durch die nunmehr am nichtinvertierenden Eingang des Operationsverstärkers 8 anstehende, vom Kompensationskondensator 10 vorgegebene Offsetspannung $U_{off}$ wird die Offsetspannung des Operationsverstärkers 8a kompensiert.

Bei dieser Anordnung sind zwar verhältnismäßig viele Schalter erforderlich, da in der Praxis die Umschalter 11 und 12 als Halbleiterschalter jeweils als zwei einzelne Schalter realisiert werden müssen. Dafür hat diese Schaltung allerdings den Vorteil, daß die Umschalter 11 und 12 die Ladung des Kompensationskondensators 10 nicht verfälschen. Halbleiterschalter haben nämlich die Eigenschaft, daß sie beim Schalten Ladungen einkoppeln. Wenn jedoch die Umschalter 11 und 12 mit identischen Halbleiterschaltern realisiert sind, heben sich die eingekoppelten Ladungen gerade auf, so daß hierdurch kein Fehler entsteht.

Das Ausführungsbeispiel nach Figur 2 unterscheidet sich bezüglich des Ausführungsbeispiels nach Figur 1 nur durch die geänderte Offsetspannungs-Kompensationsvorrichtung, so daß hier der restliche Teil der Schaltung nicht mehr erläutert wird.

In diesem Ausführungsbeispiel ist ein Anschluß des Kompensationskondensators 10 direkt an den nichtinvertierenden Eingang des Operationsverstärkers 8a und über einen Schalter 14 an den invertierenden Eingang des Operationsverstärkers 8a anschließbar. Ferner ist der Verbindungspunkt von Schalter 14 und Kompensationskondensator 10 über einen Schalter 15 mit Bezugspotential und der nichtinvertierende Eingang des Operationsverstärkers 8a über einen Schalter 16 ebenfalls mit Bezugspotential verbindbar. Die Schalter 14-16 sind wieder während der Zeitspanne Δ t dargestellt. Dabei sind die Schalter 14 und 16 geschlossen, so daß der nichtinvertierende Eingang des Operationsverstärkers 8a mit dem Bezugspotential verbunden ist und der Kompensationskondensator 10 über den Schalter 14 zwischen die beiden Eingänge des Operationsverstärkers 8a geschaltet ist. Damit lädt sich der Kompensationskondensator 10 wieder auf die Offsetspannung $U_{off}$ auf.

Nach Ende der Zeitspanne Δ t werden die Schalter 14 und 16 geöffnet und der Schalter 15 geschlossen, so daß am nichtinvertierenden Eingang des Operationsverstärkers 8a wieder die Offsetspannung ansteht und die Offsetspannungs-Kompensationsvorrichtung vom invertierenden Eingang des Operationsverstärkers 8a abgekoppelt ist. Damit wird wieder eine Kompensation der Offsetspannung $U_{off}$ erreicht, in diesem Falle jedoch mit drei einfachen Schaltern 14-16. Nachteilig ist in diesem Falle allerdings, daß sich Ladungseinkoppelungen dieser Schalter 14-16 auf den Kompensationskondensator 10 nicht aufheben. In diesem Falle müssen daher Halbleiterschalter eingesetzt werden, deren Ladungseinkopplung auf den Kompensationskondensator 10 vernachlässigbar ist.

Durch das beiden Ausführungsformen gemeinsame Zusammenwirken der Offsetspannungs-Kompensation mit der Multiplizierschaltung in der Form, daß die Offsetspannungskompensation nur erfolgt, während vom Multiplikator kein Signal kommt, wird der Einsatz einer einfachen Offsetspannungs-Kompensationsvorrichtung ohne zusätzlichen Verstärker möglich.

**Patentansprüche**

1. Elektronischer Elektrizitätszähler mit einem Modulator (1 bis 3) für Jeden Phasenleiter und einem zugeordneten Eingangsschalter (5 bis 7), wobei jeder Modulator (1 bis 3) von einer ersten Eingangsgröße ($I_1$ bis $I_3$) gesteuert ist und seinerseits den zugeordneten Eingangsschalter (5 bis 7) steuert, über den die zweite Eingangsgröße ($U_1$ bis $U_3$) jedes Phasenleiters mit einem für alle Eingangsschalter (5 bis 7) gemeinsamen Integrator (8) verbunden ist, dessen Operationsverstärker (8a) mit einer Offsetspannungs-Kompensationsvorrichtung verbunden ist, bei der ein Kompensationskondensator (10) zur Abspeicherung der Offsetspannung ($U_{off}$) von den Modulatoren (1 bis 3) periodisch mit dem einen Eingang des Operationsverstärkers (8a) verbunden wird, und dem Integrator (8) ein Komparator (9) nachgeschaltet ist, der eine Anzeigevorrichtung (17) ansteuert, **dadurch gekennzeichnet,** daß jeder Modulator (1 bis 3) von einem gemeinsamen Dreieckgenerator (4), der eine Dreiecksspannung erzeugt, deren Amplitude größer gewählt ist als die größte Stromamplitude, für die der Elektrizitätszähler zugelassen ist, so gesteuert wird, daß unabhängig von der erfaßten elektrischen Leistung in jeder Periode des Dreieckgenerators (4) während einer Zeitspanne $\Delta$ t in der Nähe der Spitze der Dreieckspannung oder jeder n-ten Zeitspanne $\Delta$ t der Kompensationskondensator (10) mit Hilfe einer Schalteranordnung (11 bis 13) parallel zu den Eingängen des Operationsverstärkers (8a) geschaltet wird und während der restlichen Periodendauer der Dreieckspannung mit Hilfe der Schalteranordnung (11 bis 13) die vom Kompensationskondensator (10) vorgegebene Offsetspannung ($U_{off}$) auf den nicht invertierenden Eingang des Operationsverstärkers (8a) geschaltet wird.

2. Elektronischer Elektrizitätszähler nach Anspruch 1, **dadurch gekennzeichnet,** daß die Schalteranordnung (11 bis 13) aus zwei Umschaltern (11, 12) und einem Einschalter (13) besteht, die den ersten Anschluß des Kompensationskondensators (10) während der Zeitspanne $\Delta$ t mit dem invertierenden Eingang des Operationsverstärkers und den zweiten Anschluß mit Bezugspotential verbinden und den nicht invertierenden Eingang des Operationsverstärkers (8a) ebenfalls mit Bezugspotential verbinden, und die Schalteranordnung (11 bis 13) während der restlichen Periodendauer der Dreieckspannung den zweiten Anschluß des Kompensationskondensators (10) mit dem nicht invertierenden Eingang des Operationsverstärkers und den ersten Anschluß des Kompensationskondensators (10) mit Bezugspotential verbindet und den nicht invertierenden Eingang des Operationsverstärkers (8a) vom Bezugspotential trennt.

3. Elektronischer Elektrizitätszähler nach Anspruch 1, **dadurch gekennzeichnet,** daß die Schalteranordnung aus drei Einschaltern (14 bis 16) besteht, die den ersten, fest mit dem nicht invertierenden Eingang des Operationsverstärkers (8a) verbundenen Anschluß des Kompensationskondensators (10) während jeder oder jeder n-ten Zeitspanne $\Delta$ t mit Bezugspotential und seinen zweiten Anschluß mit dem invertierenden Eingang des Operationsverstärkers (8a) verbinden und während der restlichen Periodendauer der Dreieckspannung den zweiten Anschluß des Kompensationskondensators (10) vom invertierenden Eingang des Operationsverstärkers (8a) trennen und mit Bezugspotential verbinden und den nicht invertierenden Eingang des Operationsverstärkers (8a) vom Bezugspotential trennen.

## Claims

1. An electronic electricity meter with a modulator (1 to 3) for each phase conductor and an associated input switch (5 to 7), wherein each modulator (1 to 3) is controlled by a first input variable ($I_1$ to $I_3$) and, for its part, controls the associated input switch (5 to 7), by way of which the second input variable ($U_1$ to $U_3$) of each phase conductor is connected to an integrator (8) which is common to all input switches (5 to 7), the operational amplifier (8a) of which is connected to an offset voltage compensation device, in which a compensation capacitor (10) for storing the offset voltage ($U_{off}$) from the modulators (1 to 3) is periodically connected to the one input of the operational amplifier (8a), and a comparator (9) is connected after the integrator (8), which comparator controls an indicating device (17), characterised in that each modulator (1 to 3) is controlled by a common delta generator (4), which generates a delta voltage, the amplitude of which is selected to be greater than the largest current amplitude, for which the electricity meter is turned on, such that independently of the measured electric performance in each period of the delta generator (4) during a time span $\Delta$ t in the proximity of the point of the delta voltage or each nth time span $\Delta$ t, the compensation capacitor (10), with the aid of a switch arrangement (11 to 13), is connected in parallel to the inputs of the operational amplifier (8a) and during the remaining period of the delta voltage, with the aid of the switch arrangement (11 to 13), the offset voltage ($U_{off}$), predetermined by the compensation capacitor (10), is connected to the non-inverting input of the operational amplifier (8a).

2. An electronic electricity meter according to claim 1, characterised in that the switch arrangement (11 to 13) consists of two reversing switches (11, 12) and a connector (13), which connect the first connection of the compensation capacitor (10) to the inverting input of the operational amplifier during the time span $\Delta$ t and the second connection to the reference potential, and also the non-inverting input of the operational amplifier (8a) to the reference potential, and the switch arrangement (11 to 13) during the remaining period of the delta voltage connects the second connection of the compensation capacitor (10) to the inverting input of the operational amplifier and the first connection of the compensation capacitor (10) to the reference potential, and separates the non-inverting input of the operational amplifier (8a) from the reference potential.

3. An electronic electricity meter according to claim 1, characterised in that the switch arrangement consists of three contactors (14 to 16), which connect the first connection of the compensation capacitor (10), firmly connected to the non-inverting input of the operational amplifier (8a), during each or each nth time span $\Delta t$ to the reference potential, and its second connection to the inverting input of the operational amplifier (8a), and during the remaining period of the delta voltage they separate the second connection of the compensation capacitor (10) from the inverting input of the operational amplifier (8a), and connect this to the reference potential and separate the non-inverting input of the operational amplifier (8a) from the reference potential.

**Revendications**

1. Compteur électronique d'électricité comportant un modulateur (1 à 3) pour chaque conducteur de phase et un interrupteur d'entrée associé (5 à 7), et dans lequel chaque modulateur (1) est commandé par une première grandeur d'entrée ($I_1$ à $I_3$) et commande, pour sa part, l'interrupteur d'entrée associé (5 à 7), au moyen duquel la seconde grandeur d'entrée ($U_1$ à $U_3$) de chaque conducteur de phase est envoyée à un intégrateur (8) commun à tous les interrupteurs d'entrée (5 à 7) et dont l'amplificateur opérationnel (8a) est raccordé à un dispositif de compensation de la tension d'offset, et dans lequel un condensateur de compensation (10) servant à mémoriser la tension d'offset ($U_{off}$) est raccordé périodiquement, par les modulateurs (1 à 3), à une entrée de l'amplificateur opérationnel (8a), et un comparateur (9), qui commande un dispositif d'affichage (17), est branché en aval de l'intégrateur (8), caractérisé par le fait que chaque modulateur (1 à 3) est commandé par un générateur commun de signaux triangulaires (4), qui produit une tension triangulaire dont l'amplitude est choisie supérieure à l'amplitude maximale du courant, pour laquelle le compteur d'électricité peut être utilisé, de manière qu'indépendamment de la puissance électrique détectée, pendant chaque période du générateur de signaux triangulaires (4), pendant l'intervalle de temps $\Delta t$ à proximité de la pointe de la tension triangulaire ou pendant chaque n-ème intervalle de temps $\Delta t$, le condensateur de compensation (10) est branché en parallèle avec les entrées de l'amplificateur opérationnel (18) à l'aide d'un dispositif de commutation (11 à 13) et que pendant le reste de la durée de la tension triangulaire, la tension d'offset ($U_{off}$), prédéterminée par le condensateur de compensation (10), est appliquée, à l'aide du montage (11 à 13), à l'entrée non inverseuse de l'amplificateur opérationnel (8a).

2. Compteur électronique d'électricité suivant la revendication 1, caractérisé par le fait que le dispositif de commutation (11 à 13) est constitué par deux commutateurs (11, 12) et par un interrupteur (13), qui relient la première borne du condensateur de compensation (10), pendant l'intervalle de temps $\Delta t$, à l'entrée inverseuse de l'amplificateur opérationnel, et relient la seconde borne au potentiel de référence et également l'entrée non inverseuse de l'amplificateur opérationnel (8a) au potentiel de référence, et que pendant la durée restante de la période de la tension triangulaire, le montage (11 à 13) relie la seconde borne du condensateur de compensation (10) à l'entrée non inverseuse de l'amplificateur opérationnel et la première borne du condensateur de compensation (10) au potentiel de référence, et déconnecte du potentiel de référence l'entrée non inverseuse de l'amplificateur opérationnel (8a).

3. Compteur électronique d'électricité suivant la revendication 1, caractérisé par le fait que le dispositif de commutation est constitué par trois interrupteurs (14 à 16), qui, pendant chaque n-ème intervalle de temps $\Delta t$, raccordent la première borne du condensateur de compensation (10), qui est raccordée de façon fixe à l'entrée non inverseuse de l'amplificateur opérationnel (8a), au potentiel de référence et relient la seconde borne du condensateur à l'entrée inverseuse de l'amplificateur opérationnel (8a) et, pendant le reste de la période de la tension triangulaire, déconnecte la seconde borne du condensateur de compensation (10), de l'entrée inverseuse de l'amplificateur opérationnel (8a) et la relie au potentiel de référence et déconnecte l'entrée non inverseuse de l'amplificateur opérationnel (8a), du potentiel de référence.

EP 0 261 526 B1

FIG 1

FIG 2